Europäisches Patentamt

European Patent Office

Office européen des brevets

(11) Publication number: **0 427 255 A2**

## EUROPEAN PATENT APPLICATION

(21) Application number: 90121382.7

(51) Int. Cl.⁵: **H01L 27/06, H01L 27/105**

(22) Date of filing: 08.11.90

(30) Priority: 10.11.89 JP 291207/89

(43) Date of publication of application:
**15.05.91 Bulletin 91/20**

(84) Designated Contracting States:
**DE FR GB**

(71) Applicant: **Kabushiki Kaisha Toshiba**
**72, Horikawa-cho Saiwai-ku**
**Kawasaki-shi(JP)**

(72) Inventor: **Kihara, Kazuo, c/o Intellectual**
**Property Division**
Kabushiki Kaisha Toshiba, 1-1 Shibaura
1-chome
Minato-ku, Tokyo 105(JP)
Inventor: Taguchi, Minoru, c/o Intellectual
Property Divisio
Kabushiki Kaisha Toshiba, 1-1 Shibaura
1-chome
Minato-ku, Tokyo 105(JP)

(74) Representative: **Lehn, Werner, Dipl.-Ing. et al**
**Hoffmann, Eitle & Partner Patentanwälte**
**Arabellastrasse 4**
**W-8000 München 81(DE)**

(54) **Semiconductor integrated circuit device and the method of manufacturing the same.**

(57) In a semiconductor integrated circuit device comprising a bipolar transistor (NPN), complementary insulated gate type transistors (NMOS, PMOS), and a charge coupled device (CCD) formed in a single semiconductor chip (1, 3), a semiconductor substrate region of one (NMOS) of the complementary insulated gate type transistors (NMOS, PMOS) and a semiconductor substrate region of the charge coupled device (CCD) are formed in an epitaxial layer (3) without separation from each other. Thus, even when a low power source voltage (e.g., 5 V) is used, circuit characteristic (increase of the linearity of the operational amplifier of the output circuit, expansion of the dynamic range, and reduction of the output impedance) can be improved.

F I G. 3

## SEMICONDUCTOR INTEGRATED CIRCUIT DEVICE AND THE METHOD OF MANUFACTURING THE SAME

The present invention relates to a semiconductor integrated circuit device and the method of manufacturing the same. More particularly, the invention relates to a semiconductor integrated circuit device in which a bipolar transistor, complementary insulated gate type transistors (CMOS), and a charge coupled device (CCD) are formed in a single semiconductor chip and the method of manufacturing the same.

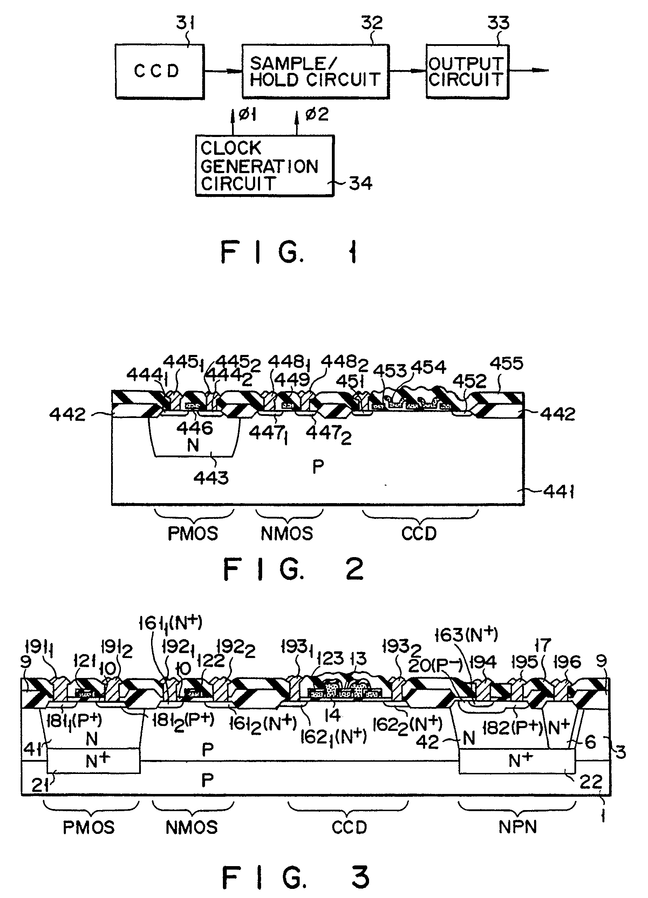

Conventionally, television receiving units and video cassette tape recorders use a semiconductor integrated circuit device incorporating a charge coupled device for realizing a video signal delaying circuit. As shown in Fig. 1, not only a charge coupled device 31, but the semiconductor integrated circuit device also incorporates a sample hold circuit 32, an output circuit 33, and a clock generating circuit 34, where these circuits are made of N-channel metal oxide semiconductor (MOS) transistors. This type of semiconductor device is called MOS/CCD integrated circuit device. In order to save power consumed by the MOS/CCD integrated circuit device comprised of the charge coupled device and the MOS transistors which are formed in a single semiconductor chip, recently, the MOS structure has been modified to a CMOS structure.

Fig. 2 designates a sectional view of a conventional CMOS/CCD integrated circuit device. The reference numeral 441 designates a P-type silicon substrate, 442 element separation region which is selectively formed in a surface region of the silicon substrate 441, and 443 an N-well region which is selectively formed in the surface region of the silicon substrate 441. The reference numerals $444_1$ and $444_2$ respectively designate a drain region and a source region of a P-channel transistor, selectively formed in the surface region of the N-well region 443. The reference numerals $445_1$ and $445_2$ respectively designate a drain electrode and a source electrode in contact with the drain region $444_1$ and the source region $444_2$. The reference numeral 446 designates a gate electrode of the P-channel transistor, formed on a gate insulating film on the silicon substrate 441. The reference numerals $447_1$ and $447_2$ respectively designate a drain region and a source region of an N-channel transistor, selectively formed in the surface region of the silicon substrate 441. The reference numerals $448_1$ and $448_2$ respectively designate a drain electrode and a source electrode in contact with the drain region $447_1$ and the source region $447_2$. The reference numeral 449 designates a gate electrode of the N-channel transistor, formed on an insulating film on the silicon substrate 441. The reference numerals 451 and 452 respectively designate a charge input region and a charge output region of a charge coupled device CCD, selectively formed in the surface region of the silicon substrate 441. The reference numeral 453 designates the first layer electrode (storage electrode) of the CCD formed on the insulating gate film on the silicon substrate 441. The reference numeral 454 designates the second layer electrode (transfer electrode) formed on the insulating gate film on the first layer electrode 453. The reference numeral 455 designates an inter-layer insulating film.

Recently, in order to accord the power source voltage used in the CMOS/CCD integrated circuit device with a power source voltage of a bipolar integrated circuit device for processing video signal used together and also in order to save power consumption, 5 V power source voltage has been used for the CMOS/CCD integrated circuit device, in place of 9 V or 12 V power source voltage.

However, when 5 V power source voltage is used, the linearity of the input/output characteristic of an operational amplifier of a CMOS structure of the output circuit degrades to decrease the yield of the CMOS/CCD integrated circuit device. Furthermore, in order to improve drive capacity of the output circuit or the clock generating circuit, both the channel width W and channel length L of the MOS transistor must be increased. This in turn results in increase of the pattern size and occupation of a wider area on the semiconductor chip.

To solve these problems, inventors of the invention had previously proposed a semiconductor integrated circuit device comprised of a bipolar transistor, CMOS transistors, and a charge coupled device formed in a single semiconductor chip, as per the Japanese Patent Application No. 1-93607 of 1989. Nevertheless, the proposed art still had problem to solve in terms of the simplification of the structure and the manufacturing process.

As mentioned above, when 5 V power source voltage is used to conventional CMOS/CCD integrated circuits, the circuit characteristic degrades and the yield lowers. Furthermore, the increase of the drive capacity of the output circuit or the clock generating circuit results in occupation of a wider area on the semiconductor chip.

The invention has been achieved to solve those problems as mentioned above. The object of the inven tion is to provide a semiconductor integrated circuit device and the method of manufacturing the same. The semiconductor integrated circuit device embodied by the invention features the following: Even when a low power voltage is used, linearity of the circuit characteristic of the operational amplifier of the output circuit can be kept stable. Yield of the semiconductor device can be improved. Even with a small pattern size, drive capacity of the output circuit or the clock generating circuit can be increased. Analogue circuit can easily be introduced.

Furthermore, the semiconductor integrated circuit device embodied by the invention increases the packing density, simplifies the signal processing system, expands the function of the integrated circuit device, saves space needed for mounting this integrated circuit device on an electronic apparatus, increases the reliability, decreases the overall cost, dispenses with additional manufacturing processes by virtue of simple structure of the semiconductor integrated circuit device.

The semiconductor integrated circuit device embodied by the invention comprises a bipolar transistor, complementary insulated gate type transistors, and a charge coupled device formed in a single semiconductor chip. The semiconductor integrated circuit device is characterized in that a semiconductor substrate region of one of the complementary insulated gate type transistors and a semiconductor substrate region of the charge coupled device are formed in an epitaxial layer without separation from each other.

The method of manufacturing the semiconductor integrated circuit device of the present invention comprises the steps of:

selectively forming, inside of a semiconductor substrate, buried layers having a high impurity concentration and of a conductivity type opposite to that of the substrate, and forming an epitaxial layer of the same conductivity type as that of the substrate on a surface of the substrate;

selectively forming the first and second well regions of the conductivity type opposite to that of the substrate inside of the epitaxial layer so that the well regions are respectively connected to the buried layers; and

forming a first insulated gate type transistor of a first channel type in the first well region, a bipolar transistor in the second well region, and a second insulated gate type transistor of a second channel type and a charge coupled device in the epitaxial layer, wherein the epitaxial layer is used as a common layer for the charge coupled device and the second insulated gate type transistor.

In the semiconductor integrated circuit device embodied by the invention, a bipolar transistor, CMOS transistors, and a charge coupled device are formed in a single semiconductor chip, and thus a signal processing system can be formed in a single semiconductor chip. Thus, even when a low power source voltage is used (e.g., 5 V), circuit characteristic (increase of the linearity of the operational amplifier of the output circuit, expansion of the dynamic range, and reduction of the output impedance) can be improved.

Furthermore, when a bipolar transistor is used for the output circuit or the clock generating circuit, the drive capacity of these circuits can be increased with a small size pattern, thus increasing the packing density.

Furthermore, since an analogue circuit can easily be introduced, the semiconductor device can be used together with other bipolar integrated circuit devices. This in turn simplifies the signal processing system, expands function of the integrated circuit device, saves space otherwise needed for mounting the semiconductor integrated circuit device on an electronic apparatus, increases the reliability, and decreases the overall cost.

Furthermore, since the semiconductor substrate region of one of the complementary insulated gate type transistors and the semiconductor substrate region of the charge coupled device are formed in a single epitaxial layer without separation from each other, the semiconductor integrated circuit device of the invention features the simple structure to dispense with additional manufacturing processes, unlike conventional CMOS/CCD integrated circuit devices.

The method embodied by the invention can manufacture the semiconductor integrated circuit device described above by combining conventional processes. Thus, according to the method of the present invention, manufacturers can easily achieve satisfactory performance characteristic of the semiconductor integrated circuit device comparable to that of conventional CMOS/CCD integrated circuit device and easy process control.

This invention can be more fully understood from the following detailed description when taken in conjunction with the accompanying drawings, in which:

Fig. 1 is a block diagram of an integrated circuit device including a CCD;

Fig. 2 designates a sectional view showing a conventional CMOS/CCD integrated circuit device;

Fig. 3 designates a sectional view showing a Bi-CMOS-CCD integrated circuit device according to an embodiment of the invention; and

Fig. 4A through 4N respectively designate sectional views at respective stages of the Bi-CMOS-CCD integrated circuit device shown in Fig. 3 during the manufacturing processes according to the present invention.

Referring now to the accompanying drawings, an embodiment of the invention is described below.

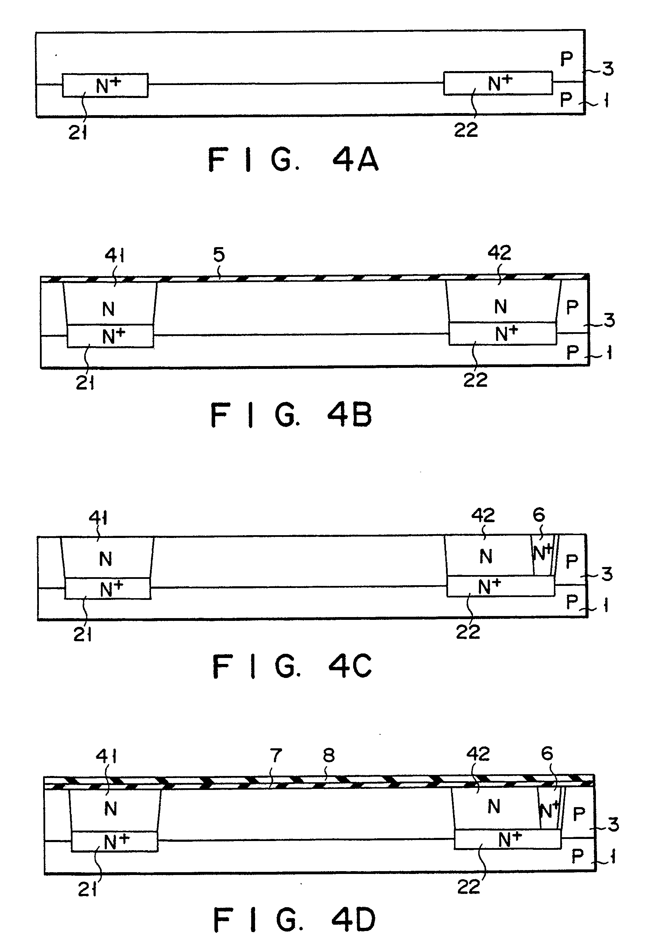

Fig. 3 designates the structure of a Bi-CMOS-CCD integrated circuit device for processing video signal made of a bipolar transistor, CMOS transistors, and a charge coupled device formed in a single semiconductor chip. The reference numeral shown in Fig. 3 designates a P-type silicon substrate having an epitaxially grown P-type epitaxial layer 3 on its surface. The reference numerals 21 and 22 designate $N^+$ buried layers having a high N-type impurity concentration selectively buried inside of the P-type silicon body. The reference numeral 9 designates element separation region (field oxide film) which is selectively formed in the surface region of the semiconductor body, in detail, in the surface region of the epitaxial layer 3. The reference numerals 41 and 42 designate N-well regions which are formed in a P-channel MOS transistor region and an NPN transistor region of the surface region of the semiconductor body, in detail, on the surface region of the epitaxial layer 3. The bottom portions of these N-well regions 41 and 42 are connected to the $N^+$ buried layers 21 and 22, respectively. The reference numeral 6 designates a deep $N^+$ region which is formed in the N-well region 42 and extends from the surface region of the semiconductor body, in detail, from the surface region of the epitaxial layer 3 to the $N^+$ buried layer 22. The reference numeral 121 designates a gate electrode of the P-channel MOS transistor, formed on the first insulating gate film 10 over the channel region of the N-well region 41. The reference numeral $181_1$ and $181_2$ respectively designate a $P^+$ drain region and a $P^+$ source region of the P-channel MOS transistor, selectively formed on the surface region of the N-well region 41. The reference numeral 122 designates a gate electrode of an N-channel transistor, formed on the first insulating gate film 10 over the channel region of the N-channel transistor region of the semiconductor body. The reference numerals $161_1$ and $161_2$ respectively designate an $N^+$ drain region and an $N^+$ source region of the N-channel transistor, which are selectively formed in the surface region of the semiconductor body, in detail, in the surface region of the epitaxial layer 3.

The reference numeral 123 designates the first-layer electrode (storage electrode) of the charge coupled device CCD, which is formed on the surface region of the semiconductor body in the CCD region, in detail, on the first insulating gate film 10 on the surface region of the epitaxial layer 3. The reference numeral 14 designates the second-layer electrode (transfer electrode) on the second insulating gate film 13 formed on the first-layer electrode 123. The reference numerals $162_1$ and $162_2$ respectively designate an $N^+$ charge input region and an $N^+$ charge output region of the CCD, which are selectively formed in the surface region of the semiconductor body, in detail, in the surface region of the epitaxial layer 3. The reference numeral 182 designates an external base region ($P^+$ region) formed in the surface region of the N-well region 42 for the NPN transistor forming region. The reference numeral 163 designates an emitter region ($N^+$ region) formed in the surface region of the $P^+$ external base region. The reference numeral 17 designates an inter-layer insulating film. The reference numerals $191_1$ and $191_2$ respectively designate a drain electrode and a source electrode which are in contact with the drain region $181_1$ and the source region $181_2$ of the P-channel MOS transistor, respectively. The reference numerals $192_1$ and $192_2$ respectively designate a drain electrode and a source electrode which are in contact with the drain region $161_1$ and the source region $161_2$ of the N-channel MOS transistor, respectively. The reference numerals $193_1$ and $193_2$ respectively designate a charge input electrode and a charge output electrode which are in contact with the charge input region $162_1$ and the charge output region $162_2$ of the CCD, respectively. The reference numerals 194, 195, and 196 respectively designate an emitter electrode, a base electrode, and a collector electrode, which are respectively in contact with the $N^+$ region 163, $P^+$ region 182, and the deep $N^+$ region 6 of the NPN transistor, respectively. The reference numeral 20 designates an internal base region ($P^-$ region) of the NPN transistor.

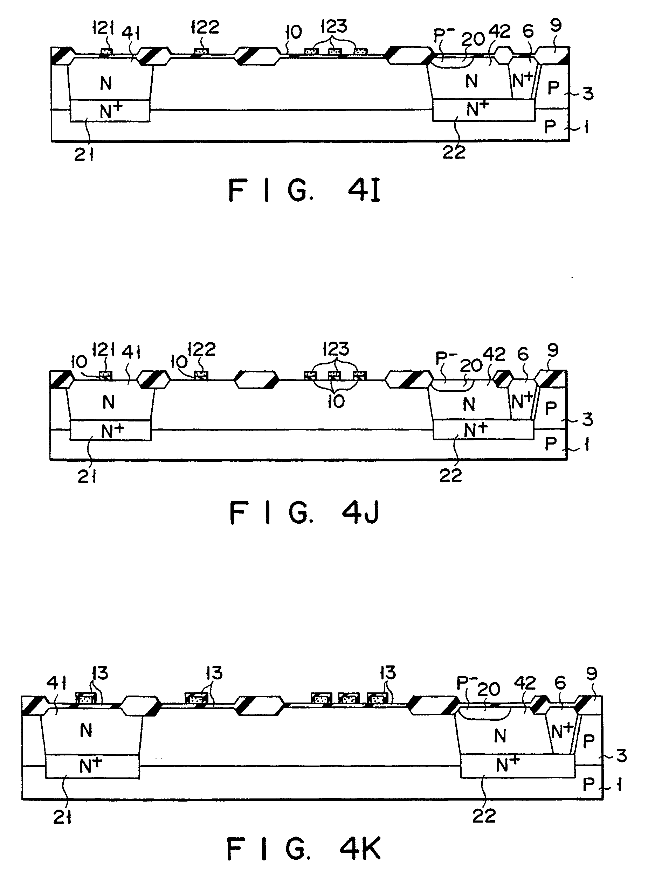

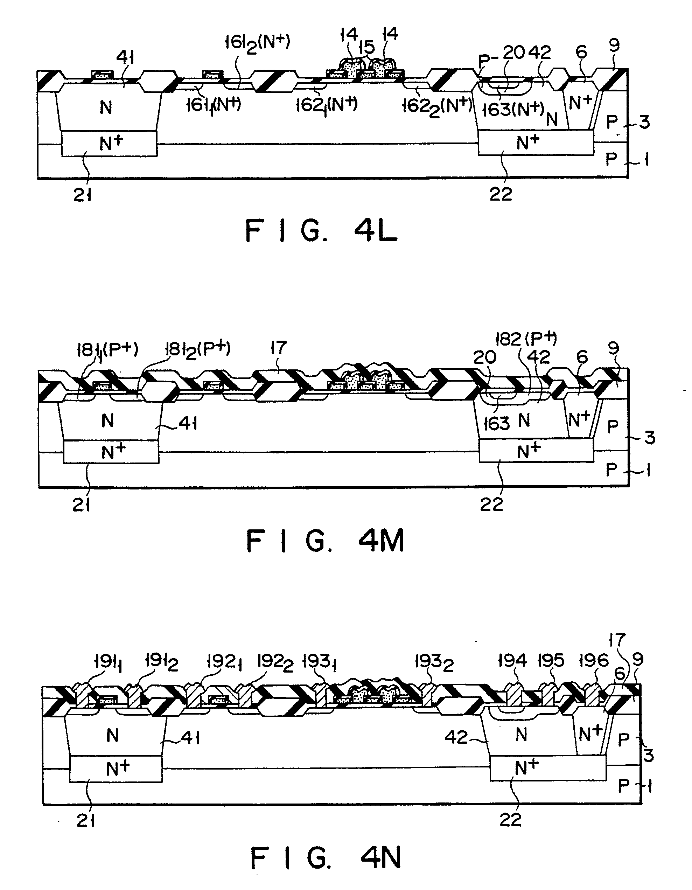

Referring to Figs. 4A through 4N, a process of manufacturing the Bi-CMOS-CCD integrated circuit device is described below.

First, by applying a conventional process, as shown in Fig. 4A, the $N^+$ layers 21 and 22 are selectively formed in the surface region of the P-type silicon substrate 1, and then the P-type epitaxial layer 3 is formed on the surface region of this substrate 1 so that the $N^+$ layers 21 and 22 are buried in the semiconductor body. Specifically, an oxide film is formed in the surface region of the P-type silicon substrate 1, portions of the oxide film are selectively etched by applying photo-etching process, and then antimony Sb is doped into the substrate using the oxide film as a mask. Resultingly, $N^+$ diffused layers of about 20 $\Omega/\square$ are selectively formed in the predetermined regions corresponding to the P-channel MOS transistor forming region and the NPN transistor forming region. The PSG film and the oxide film formed are removed by applying hydrofluoric acid (HF). The P-type epitaxial layer 3 is formed on the surface of the silicon substrate 1 by applying the epitaxial growth process. In this time, antimony doped in the $N^+$ diffused layers diffuses into the epitaxial layer 3, thus forming the $N^+$ buried layers 21 and 22 in the semiconductor body. The impurity concentration $\rho_{vG}$ of the epitaxial layer 3 is selected to a value so that the epitaxial layer has a resistivity (about 10 to 30 $\Omega \cdot cm$) suited for the CCD. On the other hand, the thickness tvG of the epitaxial layer 3 is selected to a value (about 3 to 5 $\mu$m) suited for the bipolar transistor.

Next, oxidation is again executed to form an oxide (SiO₂) film 5 having about 500 Å in thickness tox over the surface of the epitaxial layer 3 as shown in Fig. 4B. By applying photo-etching process, portions of the oxide film 5 are selectively etched which correspond to the N well forming regions. By using a photo-resist pattern (not shown) as a blocking mask, phosphorus ions are injected into the epitaxial layer 3 under the conditions of accelerating voltage Vac = 100 KeV and dosing amount Qd × 2.0 $10^{12}$ cm⁻². By applying a thermal treatment to the injected ions at 1100°C for 30 minutes in N₂ gas, the injected ions are diffused into the epitaxial layer 3 to form the N-well regions 41 and 42. The N-well regions 41 and 42 are respectively connected to the N⁺ buried layers 21 and 22.

Next, by applying photo-etching process, a portion of the oxide film 5 is etched which corresponds to the deep N⁺ region forming region. Phosphorus ions are injected into the N-well region 42 using a photo-resist pattern (not shown) as a blocking mask under the conditions of accelerating voltage Vac = 50 KeV and dosing amount Qd = 5.0 × $10^{15}$ cm⁻². By applying a thermal treatment to the injected ions at 1100°C for 30 minutes in N₂ gas, the injected ions are diffused into the N-well region 42 to form the deep N⁺ region 6 in connection with the N⁺ buried layer 22 as shown in Fig. 4C. The oxide film 5 is removed.

Next, as shown in Fig. 4D, an oxide (SiO₂) film 7 having about 900 Å in thickness tox is formed over the surface of the semiconductor body. Furthermore, a silicon nitride (Si₃N₄) film 8 having about 2000 Å in thickness is formed over the SiO₂ film 7.

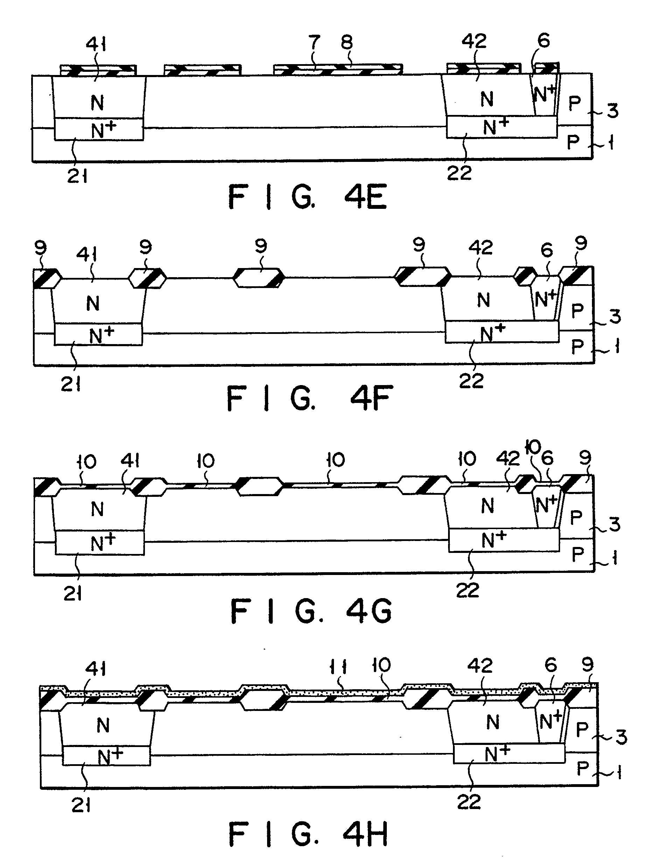

Next, a photo-resist pattern (not shown) for defining an element separation region is formed over the surface of the silicon nitride film 8, and then, using the pattern as a mask, as shown in Fig. 4E, an etching process is applied to the silicon nitride (Si₃N₄) film 8 and the SiO₂ film 7. Another photo-resist pattern (not shown) for defining a P⁻ inversion preventing layer is formed, and then, using the pattern as a blocking mask, boron ions are injected into the semiconductor body under the conditions of accelerating voltage Vac = 50 KeV and dosing amount Qd = 8.0 × $10^{13}$ cm⁻². A further photo-resist pattern (not shown) for defining an N⁻ inversion preventing layer is formed, and then using the pattern as a blocking mask, phosphorus ions are injected into the semiconductor body under the conditions of accelerating voltage Vac = 100 KeV and dosing amount Qd = 5.0 × $10^{12}$ cm⁻².

Next, as shown in Fig. 4F, by applying a thermal oxidation process at 1000°C, field oxide (SiO₂) film 9 for defining an element separation region having 9500 Å in thickness tox is formed. By applying a chemical dry etching process, the Si₃N₄ film 8 is removed from the element forming regions. Furthermore, the SiO₂ film 7 is removed from the element forming regions by applying NH₄F solution.

Next, as shown in Fig. 4G, by executing a thermal oxidation process at 950°C in a mixed gas of 02 and HCℓ, the first gate oxide film (SiO₂ film) 10 having about 670 Å in thickness tox is formed on the superficial region of the semiconductor body.

Next, a predetermined channel doping is applied to the CCD forming region and the N-channel MOS transistor forming region (both in the surface region of the epitaxial layer 3) and to the P-channel MOS transistor forming region (surface region of the N-well region 41).

Next, by applying a CVD process, as shown in Fig. 4H, a first polycrystal silicon film 11 having about 3900 Å in thickness tpoly is formed over the semiconductor structure. The first polycrystal silicon film 11 is then thermally treated at 1000°C in POCℓ₃ gas to make the polycrystal silicon film 11 conductive.

Next, by applying the photo-etching process and the reactive ion etching (RIE) process, the polycrystal silicon film 11 is patterned so that, as shown in Fig. 4I, the first-layer electrode (storage electrode) 123 of the CCD, the gate electrode 122 of the N-channel MOS transistor, and the gate electrode 121 of the P-channel MOS transistor are formed. A patterning corresponding to the inner base region of the NPN transistor is executed, and then boron ions are injected into this region under the conditions of accelerating voltage Vac = 40 KeV and dosing amount Qd = 3.0 × $10^{14}$ cm⁻².

Furthermore, another patterning is applied to the barrier region of the transfer channel of the CCD, and then boron ions are injected into the barrier region under the conditions of Vac = 40 KeV and Qd = 7.7 × $10^{11}$ cm⁻². An annealing process is applied to the boron-doped region at 900°C for 30 minutes in N₂ gas. As a result, P⁻ type inner base region 20 and the channel of the CCD are formed. As shown in Fig. 4J, the oxide film 10 is selectively removed by applying NH₄F solution.

Next, a thermal oxidation process is executed at 950°C in a mixed gas of O₂ and HCℓ, and as a result, the second gate oxide (SiO₂) film 13 having about 670 Å in thickness tox is formed over the semiconductor structure, as shown in Fig. 4K.

Next, by applying a CVD process, a second polycrystal silicon film having about 3900 Å in thickness tpoly is formed over the semiconductor structure. The second polycrystal silicon film is then thermally treated at $1000°C$ in $POC\ell_3$ gas, and thus, the second polycrystal silicon film is made conductive. By applying the photo-etching process and the chemical dry etching process, the polycrystal silicon film is patterned to form the second-layer electrode (transfer electrode) 14 of the CCD, as shown in Fig. 4L. A further photo-etching process is executed for the formation of $N^+$ regions, using as a mask (not shown), to selectively remove the second gate oxide film 13. Arsenic ions are implanted into the semiconductor body under the conditions of Vac = 40 KeV and Qd = 5.0 $10^{15}$ $cm^{-2}$, and a thermal oxidation is performed at $1000°C$ for 20 minutes in 02 gas.

Consequently, arsenic ions doped in the semiconductor body diffuse, thus forming the $N^+$ drain region 1611 and the $N^+$ source region $161_2$ of the N-channel transistor, the charge input region $162_1$ and the charge output region $162_2$ of the charge coupled device, and the $N^+$ emitter region of the NPN transistor. In the thermal oxidation process, an oxide ($SiO_2$) film 15 is formed on the surface of the transfer electrode 14.

Next, as shown in Fig. 4M, a further photoetching process is executed to the oxide film 13, using as a mask (not shown), for the formation of the drain region $181_1$ and the source region $181_2$ of the P-channel transistor and the external base region 182 of the NPN transistor, and using the patterned film as a blocking mask, boron ions are injected into the semiconductor body under the conditions of Vac = 40 KeV and Qd = 2.0 × $10^{15}$ $cm^{-2}$. Thereafter, by applying the CVD process, an undoped CVD oxide film having about 3000 Å in thickness, a boron-phosphorus-silicated glass (BPSG) film having about 9000 Å in thickness, and the phosphorus-silicated glass (PSG) film having about 2500 Å in thickness (these films being shown in Fig. 4N in a of a single inter-layer insulating film 17) are sequentially formed, which are then subjected to a phosphorusgettering and a thermal treatment at 950.C in $POC\ell_3$ gas.

As a result, boron ions doped in the semiconductor body diffuses so that the $P^+$ drain region $181_1$ and the $P^+$ source region $181_2$ of the P-channel transistor and the $P^+$ external base region 182 of the NPN transistor are formed.

Next, as shown in Fig. 4N, a further photo-etching process is executed so that a photo-resist pattern (not shown) is formed over the semiconductor structure to define contact regions. Using the photo-resist pattern as a mask, a chemical dry etching and a reactive ion etching process are executed to form electrode contact holes in the insulating film 17. Metal or metal compound, typically aluminium, is sputtered and then formed into a pattern to form electrodes and wires. By way of the sputtering and patterning, there are formed electrodes $191_1$ and $191_2$ in contact with the drain region $181_1$ and the source region $181_2$ of the P-channel MOS transistor, respectively, electrodes $192_1$ and $192_2$ in contact with the drain region $161_1$ and source region $161_2$ of the N-channel MOS transistor, respectively, electrodes $193_1$ and $193_2$ in contact with the charge input region $162_1$ and the charge output region $162_2$ of the CCD, respectively, an emitter electrode 194, a base electrode 195, and a collector electrode 196 in contact with the $N^+$ region 163, $P^+$ region 182, and the deep $N^+$ region 6 of the NPN transistor, respectively.

Next, by executing a sintering process to aluminium constituting the electrodes 1911 through 195 at $450°C$ for 15 minutes in $N_2/H_2$ gas, those electrodes are activated. By applying a CVD process, a passivation film (not shown) is formed. A further photo-etching process is executed to form a bonding-pad region to complete the whole processes for manufacturing the semiconductor integrated circuit device of the invention.

According to the semiconductor integrated circuit device embodied by the invention, a bipolar transistor, CMOS transistors, and a charge coupled device, are formed in a single semiconductor chip to allow a video signal processing system to be formed in a single semiconductor chip. Thus, even when using a low power source voltage (e.g., 5 V), circuit characteristics (the linear characteristic of the operational amplifier of the output circuit, expansion of dynamic range, and decrease of the output impedance, etc.) of the semiconductor integrated circuit device embodied by the invention are improved.

Furthermore, according to the semiconductor integrated circuit device embodied by the invention, when a bipolar transistor is used to form the output circuit or the clock generating circuit, even a small pattern size increases the capacity for driving these circuits, thus increasing the packing density. Furthermore, since analogue circuits can easily be introduced, these analogue circuits can also be integrated together with other bipolar integrated circuit devices concurrently used. This in turn contributes to simplify a signal processing system, expand the function of integrated circuit device, save space needed for mounting the embodied semiconductor integrated circuit device in an electronic apparatus, increase the reliability, and reduce the manufacturing cost.

Furthermore, according to the semiconductor integrated circuit device embodied by the invention, the semiconductor substrate region of one of the CMOS transistors and the semiconductor substrate region of the charge coupled device are formed in a single epitaxial layer 3 without being separated from each other. Thus, the structure of the semiconductor integrated circuit device is simple, thus minimizing additional processes compared to the case of manufacturing conventional CMOS/CCD integrated circuit device. The P-type epitaxial layer 3 on the surface of the P-type substrate is used as a common semiconductor substrate for both the CCD and the N-channel MOS transistor. Moreover, the $N^+$ buried layer 21 is formed on the bottom of the N-well region 41 (i.e., the substrate of the P-channel MOS transistor). The semiconductor device of the present invention differs from conventional CMOS/CCD integrated circuit devices in these structures. In comparison with conventional CMOS/CCD integrated circuit devices, additional processes are only those for forming the $N^+$ buried layers 21 and 22, the P-type epitaxial layer 3, the deep $N^+$ region 6, and the $P^-$ internal base region 20 of the NPN transistors.

As is clear from the above description, according to the semiconductor integrated circuit device embodied by the invention, even when using a low power voltage, circuit characteristic of the operational amplifier of the output circuit and the yield can be improved. For example, compared to the case in which 5 V power source voltage was introduced to a conventional CMOS/CCD integrated circuit device, the yield in the die-sorting stage of the manufacturing process increased by about 30% in the case of the semiconductor integrated circuit device embodied by the invention. Furthermore, even a small pattern can increase the capacity for driving the output circuit or the clock generating circuit. Moreover, since analogue circuits can easily be introduced, the present invention contributes to simplify a signal processing system, expand the function of integrated circuit devices, save space needed for installing the embodied semiconductor integrated circuit device in an electronic apparatus, increase the reliability, and reduce the manufacturing cost. Furthermore, the present invention provides a simple structure of the semiconductor integrated circuit device to minimize additional processes for manufacturing the semiconductor integrated circuit device.

Furthermore, according to the method of manufacturing the semiconductor integrated circuit device embodied by the invention, since the semiconductor integrated circuit device can be manufactured by combining conventional processes. Thus, the invented manufacturing method can realize a satisfactory performance characteristic equivalent to that of conventional CMOS/CCD integrated circuit devices and an easy process control.

In the light of those advantages thus far described, the semiconductor integrated circuit device embodied by the invention is effective to form a video signal processing integrated circuit device for a television receiving unit, a video cassette tape recorder, a movie camera, or the like. The method of manufacturing the semiconductor integrated circuit device embodied by the invention also provides those features as mentioned above.

Reference signs in the claims are intended for better understanding and shall not limit the scope.

## Claims

1. A semiconductor integrated circuit device comprising a bipolar transistor (NPN), complementary insulated gate transistors (NMOS, PMOS), and a charge coupled device (CCD) formed in a single semiconductor chip (1, 3), characterized in that a semiconductor substrate region of one (NMOS) of said complementary insulated gate type transistors and a semiconductor substrate region of said charge coupled device (CCD) are formed in an epitaxial layer (3) without separating from each other.

2. The semiconductor integrated circuit characterized by comprising:
a P-type semiconductor body (1, 3) comprising a semiconductor substrate (1) having an epitaxially grown P-type epitaxial layer (3) formed on said substrate;
N-type buried layers (21, 22) which are selectively formed inside of said semiconductor body;
N-well regions (41, 42) which are respectively formed in a P-channel MOS transistor (PMOS) forming region and an NPN bipolar transistor forming region both in a surface region of said semiconductor body; and
a semiconductor substrate region of an N-channel MOS transistor (NMOS) and a semiconductor substrate region of a charge coupled device (CCD) respectively formed in said P-type epitaxial layer without separating from each other.

3. A method of manufacturing a semiconductor integrated circuit characterized by comprising the steps of:
selectively forming, inside of a semiconductor substrate (1), buried layers (21, 22) having a high impurity concentration and of a conductivity type opposite to that of said substrate, and forming an epitaxial layer (3) of the same conductivity type as that of said substrate on a surface of said substrate;
selectively forming the first and second well regions (41, 42) of the conductivity type opposite to that of said substrate inside of said epitaxial layer so that said well regions are respectively connected to said buried layers; and
forming a first insulated gate type transistor (PMOS) of a first channel type in said first well region (41), a bipolar transistor (NPN) in said second well region (42), and a second insulated gate type transistor (NMOS) of a second channel type and a charge coupled device (CCD) in said epitaxial layer, wherein said epitaxial layer is used as a common layer for said charge coupled device and said second insulated gate type transistor.

4. The method of manufacturing a semiconductor integrated circuit characterized by comprising the steps of:

selectively forming, inside of a P-type silicon substrate (1), $N^+$ buried layers (21, 22) of a high N-type impurity concentration, and forming a P-type epitaxial layer (3) on a surface of said substrate;

selectively forming first and second N-well regions (41, 42) in said P-type epitaxial layer so that said first and second N-well regions are respectively connected to said $N^+$ buried layers;

forming in said second N-well region (42) a deep $N^+$ region (6) connected to one (22) of said $N^+$ buried regions, and selectively forming a field oxide film (9) for element-separation on the surface of said P-type epitaxial layer;

forming a first gate oxide film (10) on the surface of said P-type epitaxial layer;

doping impurities into a forming region in the surface of said P-type epitaxial layer for a charge coupled device (CCD) and an N-channel MOS transistor (NMOS) and into a forming region in said first N-well region (41) for a P-channel MOS transistor (PMOS);

forming a first-layer electrode (123) of said charge coupled device, a gate electrode (122) of said N-channel MOS transistor, and a gate electrode (121) of said P-channel MOS transistor;

forming an internal base region (20) of an NPN transistor in said second N-well region and a buried channel of said charge coupled device in said P-type epitaxial layer;

forming a second gate oxide film (13) on the surface of said first-layer electrode;

forming a second-layer electrode (14) of said charge coupled device;

forming a drain region ($161_1$) and a source region ($161_2$) of said N-channel MOS transistor, a charge input region ($162_1$) and a charge output region ($162_2$) of said charge coupled device, a drain region ($181_1$) and a source region (1812) of said P-channel MOS transistor, and the external base region (182) of said NPN transistor; and

forming an inter-layer insulating film (17), opening an electrode contact hole in the insulating film, forming electrodes ($191_1$, $191_2$, $192_1$, $192_2$, $193_1$, $193_2$, 194, 195, 196) and wires made from metal or metal compound, and forming a passivation film.

F I G. 1

F I G. 2

F I G. 3

F I G. 4A

F I G. 4B

F I G. 4C

F I G. 4D

F I G. 4E

F I G. 4F

F I G. 4G

F I G. 4H

FIG. 4I

FIG. 4J

FIG. 4K

F I G. 4L

F I G. 4M

F I G. 4N